# EUROPEAN PATENT APPLICATION

(11) **EP 0 552 914 A1**
(43) Date of publication of application: **28.07.1993**
(21) Application number: 93300320.4
(22) Date of filing: 19.01.1993
(51) Int. Cl.: H05K 13/04

(54) **Tool holder assembly for surface mount machine**

(30) Priority: 21.01.1992 US 824813
(71) Applicant: EMHART INC., Newark, Delaware 19711 (US)
(72) Inventor: Gaudette, Arthur L., Ipswich, Massachusetts 01938 (US)
(74) Representative: Stagg, Diana Christine

(57) **Abstract**

A machine for placing surface mount components on a printed circuit board comprising a vertically displaceable tool head 14 including, a tool holder 16 rotatable about a vertical axis and including an inlet port 22 and air conduit 20 communicating with the inlet port 22. The tool holder 16 further comprises a cylindrical outer surface having an annular groove 48 communicating with the air conduit 20, a rotary union 52 including an interior cylindrical bore for mating engagement with the cylindrical outer surface and an inlet conduit 50 communicating with the interior cylindrical bore, means for mounting the tool holder 16 with the cylindrical outer surface within the interior cylindrical bore of the rotary union 82 so that the rotary union inlet conduit 50 is selectively located to communicate with the annular groove 48 of the tool holder 16, and means for preventing the rotation of the rotary union 52.

## Description

The present invention relates to a machine for placing surface mount components on printed circuit boards.

Conventionally, surface mount electronic components are picked up by engaging the top flat surface of the component with a vacuum tool. The component may be re-oriented before placement and such angular re-orientation (theta movement) can exceed 180°. The orientation of the tool must usually be monitored so that the vacuum hose does not wind up causing a problem. To avoid the problem of hose windup, components may be re-oriented in a direction that requires the greatest theta movement and this reduces the productivity of the machine.

It is accordingly an object of the present invention to provide a tool holder which can always be rotated to the desired placement orientation by rotating the tool by the smallest theta angle.

The present invention provides a machine for placing surface mount components on a printed circuit board comprising
a vertically displaceable tool head including,
a tool holder rotatable about a vertical axis and including
an inlet port,
an air conduit communicating with the inlet port and
a cylindrical outer surface having an annular groove communicating with the air conduit,
a rotary union including an interior cylindrical bore for mating engagement with the cylindrical outer surface and an inlet conduit communicating with the interior cylindrical bore,
means for mounting the tool holder with the cylindrical outer surface within the interior cylindrical bore of the rotary union so that the rotary union inlet conduit is selectively located to communicate with the annular groove of the tool holder, and means for preventing the rotation of the rotary union.

An embodiment of a machine according to the invention will now be described with reference to the accompanying drawings, in which;

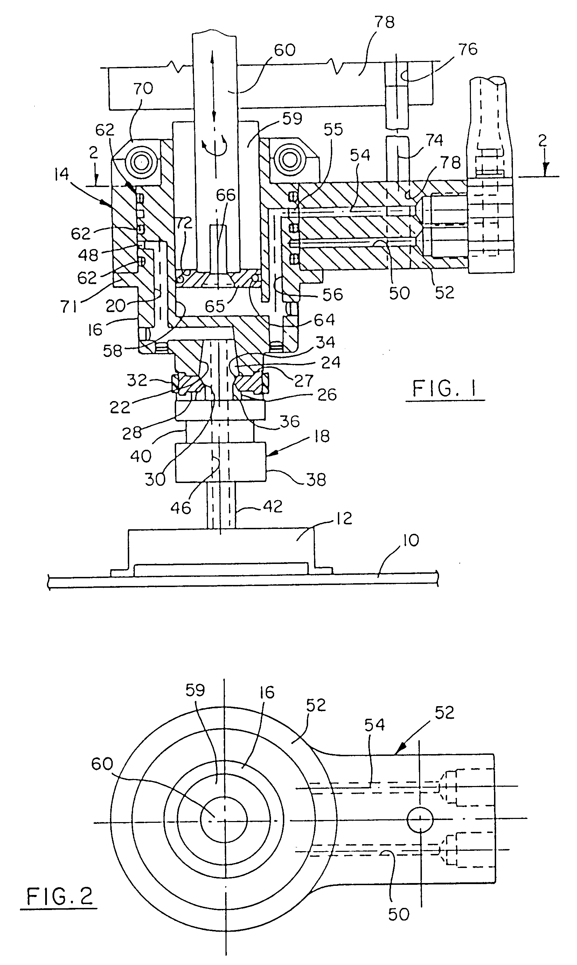

Figure 1 is an elevational cross sectional view of a tool head of a machine for placing surface mount electronic components on printed circuit boards; and
Figure 2 is a view taken on line 2-2 of Figure 1.

A printed circuit board 10 to be populated with surface mount components 12, is supported on a slide (not shown) for horizontal displacement and a tool head 14 which is also supported for horizontal displacement, is vertically displaceable and rotatable about its axis to place the components on the printed circuit board. The tool head assembly 14 includes a tool holder 16 and a tool 18. The tool holder 16 has an interior vacuum line 20 which communicates with an outwardly tapered, conical port 22. A similarly tapered head 24 of the tool 18 is matingly received by this tapered port 22 and forced engagement therebetween is achieved by a plurality (three) of detents 26, each being shaped like a rivet having a head 27, a cylindrical body 28 and a spherical end 30, which are urged inwardly by an elastic band 32 against the arcuate, annular surface 34 connecting the tapered head 24 to a reduced diameter portion 36.

The middle portion 38 of the tool 18 is cylindrical and has an annular circumferential groove 40. The tool ends with a tip 42 for engaging the component 12. The tool holder vacuum line 20 connects a vacuum conduit 46 in the tool with an annular groove 48 in the tool holder which communicates with one of the inlet lines 50 of a rotary union 52. This permits unlimited theta rotation of the tool holder in either direction so that any desired theta re-orientation can be achieved by rotating the tool holder through the smallest possible angle. A second inlet line 54 communicates via an annular tool holder groove 55 and conduit 56 with a central blind bore 58 which receives a preloaded ball spline nut 59 which slidably receives the ball spline 60 (the tool holder shaft). This permits relative axial movement between the ball spline nut 59 and the shaft 60 while joining them for rotational displacement.

Three sealing rings 62 establish a seal on either side of the annular grooves 48, 55 and a fourth sealing ring 64 which is supported by a cylindrical disc 65 secured via a screw 66 to the shaft 60 establishes a seal between the tool holder shaft 60 and the central blind bore 58.

A clamping collar 70 secures the ball spline nut 59 to the tool holder and locates the rotary union 52 between the tool holder flange 71 and the collar 70. Compliant movement can then occur between the tool holder shaft 60 and the ball spline nut and hence the tool holder to compensate for variations in tool holder Z positioning whether due to board warpage or otherwise. The bottom surface 72 of the ball spline nut 59 functions as the upward stop for the disc 65 and hence the tool shaft 60. The rotary union 52 is prevented from rotating by a sliding pin 74 which is secured to the rotary union 52 and which is slidably received by a suitable hole 76 in the frame 78. Compressed air to the central blind bore can be programmably regulated to establish a selected compliant pressure.

The tool holder may accordingly be rotated in either direction without limitation and accordingly, can be programmed to rotate the shortest distance at any time.

## Claims

1. A machine for placing surface mount components on a printed circuit board comprising
a vertically displaceable tool head including,
a tool holder 16 rotatable about a vertical axis and including
an inlet port 22 and
an air conduit 20 communicating with the inlet port 22, characterised in that the tool holder 16 has a cylindrical outer surface having an annular groove 48 communicating with the air conduit 20,
a rotary union 52 including an interior cylindrical bore for mating engagement with the cylindrical outer surface and an inlet conduit 50 communicating with the interior cylindrical bore,
means 70 for mounting the tool holder 16 with the cylindrical outer surface within the interior cylindrical bore of the rotary union 52 so that the rotary union inlet conduit 50 is selectively located to communicate with the annular groove of the tool holder, and
means 74, 78 for preventing the rotation of the rotary union.

2. A machine according to claim 1 further characterised in that the tool holder comprises a ball spline 60 axially displaceable and rotatably movable about its axis, a ball spline nut 59 operatively associated with the ball spline and means for securing the ball spline nut 59 to the tool holder 16.
